(19) Europäisches Patentamt
European Patent Office
Office européen des brevets

(11) EP 3 037 572 B1

(12) # EUROPEAN PATENT SPECIFICATION

(45) Date of publication and mention of the grant of the patent:
**24.04.2019 Bulletin 2019/17**

(51) Int Cl.:
*C25D 3/38* (2006.01) *C25D 3/58* (2006.01)
*C25D 7/00* (2006.01)

(21) Application number: **15194674.6**

(22) Date of filing: **16.11.2015**

(54) **ELECTROLYTIC COPPER PLATING SOLUTION**

LÖSUNG ZUR ELEKTROLYTISCHEN KUPFERABSCHEIDUNG

SOLUTION DE PLACAGE ÉLECTROLYTIQUE DE CUIVRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.12.2014 JP 2014266608**

(43) Date of publication of application:
**29.06.2016 Bulletin 2016/26**

(73) Proprietor: **Rohm and Haas Electronic Materials LLC**
**Marlborough, MA 01752 (US)**

(72) Inventors:
- **MIZUNO, Yoko**
  **Agano-Shi, Niigata (JP)**
- **SAKAI, Makoto**
  **Agano-Shi, Niigata (JP)**
- **SAITO, Mutsuko**
  **Agano-Shi, Niigata (JP)**
- **MORINAGA, Toshiyuki**
  **Agano-Shi, Niigata (JP)**
- **HAYASHI, Shinjiro**
  **Agano-Shi, Niigata (JP)**

(74) Representative: **Houghton, Mark Phillip et al**
**Patent Outsourcing Limited**
**1 King Street**
**Bakewell, Derbyshire DE45 1DZ (GB)**

(56) References cited:
**EP-A2- 1 001 054** **US-A1- 2005 072 683**
**US-A1- 2010 084 277** **US-B1- 6 183 545**

- **Atsuki Nogami ET AL: "Fine-pitch and High-density Printed Circuit Board", Fujikura Technical Review, 1 January 2010 (2010-01-01), XP055506374, Retrieved from the Internet: URL:http://www.fujikura.co.jp/eng/rd/gihou/backnumber/pages/__icsFiles/afieldfile/2010/04/19/39e_09.pdf [retrieved on 2018-09-11]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 037 572 B1

## Description

Filed of the Invention

The present invention relates to an electrolytic copper plating solution, and more specifically, to an electrolytic copper plating solution used to obtain a rectangular copper deposit and a method to obtain the rectangular copper using said plating solution.

Background of the Invention

Conventionally, semi-additive process has been used to produce printed circuit boards whose fine pitch circuits have a pattern with a line width ranging from a few to dozens of micro-meters. In the production method of printed circuit boards through the semi-additive process, sputtering process or vacuum evaporation process is used to form a conductive metal layer (also referred to as conductive seed layer) with a film thickness ranging from dozens to hundreds of nanometers and then a resist layer is formed on its surface. Next, a plating resist layer is formed where plating is not needed through exposure and development. Then, the conductive seed layer is energized and a copper circuit is formed in a resist-free part through electrolytic plating process, and a circuit pattern consisting of a conductive seed layer and an electrolytic plating layer is formed by stripping the plating resist. Then, an insulation layer is formed and electronic parts are installed to produce a printed circuit board. To form a fine pitch circuit on a printed circuit board, it is necessary to provide copper plating inside the gap between resists (resist patterns) with a depth ranging from about 5 to about 30 micro-meters and a width ranging from a few to dozens of micro-meters to form a copper circuit (copper circuit pattern).

Usually, because the copper circuit pattern is formed perpendicular to the board substrate (bottom), the section of the copper circuit takes a rectangular shape whose top is flat or substantially flat and whose sides are at a right angle or substantially right angle to the bottom or the top. However, when providing copper plating inside the resist patterns at a small interval, it is difficult for the plating current to flow through a two-sided corner parts on the bottom of the resist patterns, i.e., corner parts on the bottom and sides of the gap, and agitation of plating solution inside an opening of the resist patterns is insufficient, making it difficult to deposit the plating metal. Therefore, when observing a section of the circuit pattern after resist stripping, it will be found that the top part of the copper circuit pattern section is descending at both ends (also referred to as "round shape" hereinafter in this description) instead of being flat. In such a circuit, the inter-layer connection and wire bonding or solder bonding will have problems and the thickness of the plating film will be smaller compared to a circuit whose conductive section is rectangular, so improvement is needed. Additionally, in the case that a via exists in a board which has a fine pitch circuit (for example, with a diameter of 30 to 80 micro-meters), it is necessary to perform copper plating for both the resist patterns and the via at the same time. However, if the width of the gap of the resist patterns is different from the diameter of the via, a conventional copper plating solution will have problems in terms of copper circuit pattern shape or insufficient copper deposit where there is a void inside the via, so improvement is needed.

Conventionally, there are various surfactants used in electrolytic copper plating. For example, Japanese patent publication No. 2005-126740 discloses an electrolytic plating bath where a glycine amphoteric surfactant and benzyl ammonium chloride cation are used in combination. Also, Japanese patent publication No. 2004-307898 discloses an acidic copper plating solution where two or more kinds of high-molecular-weight surfactants with different hydrophobicity are used in combination. The two or more kinds of high-molecular-weight surfactants with different hydrophobicity disclosed are two or more kinds of non-ionic surfactants or non-ionic surfactants plus other surfactants. Other surfactants disclosed are amphoteric surfactants. However, according to the experiment conducted by the inventors of this invention, in the event of combined use of an amphoteric surfactant and cation surfactant, copper deposit of a fine pitch circuit pattern is insufficient and the section of the circuit pattern formed is of a round shape. Additionally, in the event of combined use of a polymer non-ionic surfactant and polymer amphoteric surfactant, copper deposit inside a via is insufficient. Therefore, this method cannot be used for a board which has both a fine resist pattern and a via. US2010/084277 discloses a composition for copper plating and associated methods, a method of forming a copper wiring including forming an insulation layer having a recessed portion on a substrate, and forming a copper layer on the insulation layer to fill the recessed portion by performing an electroplating process using a composition that includes an aqueous electrolyte solution containing a copper ion and at least one of a disulfide compound, a betaine compound, and a triblock copolymer of polyethylene oxide-polypropylene oxide-polyethylene oxide (PEO-PPO-PEO) having a weight average molecular weight of about 2,500 to about 5,000 g/mol and an ethylene oxide content (EO %, w/w) of about 30% to about 60%. US2005/072683 discloses an acid copper plating solution comprises copper ions, an organic acid or an inorganic acid, chloride ions, a high molecular weight surfactant that controls the electrodeposition reaction, and a sulfur-containing saturated organic compound that promotes the electrocoating rate. "Fine-pitch and High-density Printed Circuit Board" to Atsuki Nogami et al in Fujikura Technical Review (01 Jan 2010), discloses the demand for high-density printed circuit boards has risen along with the trend of lighter, thinner, and smaller electronic equipment and the mounting

parts and that of an increase in the number of multi pins of ICs.

Therefore, it is desired to develop an electrolytic copper plating solution which can deposit copper on both ends of the circuit pattern and form a fine pitch circuit that has a rectangular section and which allows good via-filling.

## Summary of the Invention

The present invention, in its various aspects, is as set out in the accompanying claims.

An electrolytic copper plating solution, characterized in that it contains a non-ionic surfactant and alkyl betaine surfactant.

The main purpose of this invention is to provide an electrolytic copper plating solution which can obtain a narrow circuit pattern such as a fine pitch circuit pattern whose section is rectangular as compared to the conventional technology and allows good via-filling as well.

The inventors found that an electrolytic copper plating solution which uses a non-ionic surfactant and an alkyl betaine surfactant in combination can obtain a circuit pattern that has a rectangular section and conduct via-filling well, thereby achieving the invention.

## Brief Description of the Drawings

Figure 1 is a microscope photograph which shows the ultra-deep shape of a plating section of a pattern with a line/space ratio (L/S) of 20μm/20μm obtained in Example 1.

Figure 2 is a microscope photograph which shows the ultra-deep shape of a plating section of a pattern with a width of 100μm obtained in Example 1.

Figure 3 is a microscope photograph which shows the ultra-deep shape of a plating section of a pattern with a line /space ratio (L/S) of 20μm/20μm obtained in Example 2.

Figure 4 is a microscope photograph which shows the ultra-deep form of a plating section of a pattern with a width of 100μm obtained in Example 2.

Figure 5 is a microscope photograph which shows the ultra-deep form of a plating section of a pattern with a line /space ratio (L/S) of 20μm/20μm obtained in Example 3.

Figure 6 a microscope photograph which shows the ultra-deep form of a plating section of a pattern with a line /space ratio (L/S) of 20μm/20μm obtained in Reference Example 2.

Figure 7 is a microscope photograph which shows the ultra-deep form of a plating section of a pattern with a width of100μm obtained in Reference Example 2.

Figure 8 is a microscope photograph which shows the ultra-deep shape of a plating section of pattern with line/space ratio (L/S) of 20μm/20μm obtained in Reference Example 3.

Figure 9 is a microscope photograph which shows the ultra-deep shape of a plating section of a pattern with a line/space ratio (L/S) of 20μm/20μm obtained in Reference Example 4.

Figure 10 is a microscope photograph which shows the ultra-deep shape of a plating section of a pattern with a line/space ratio (L/S) of 20μm/20μm obtained in Example 4.

Figure 11 is a microscope photograph which shows the ultra-deep shape of a plating section of a pattern with a width of 100μm obtained in Example 4.

Figure 12 is a microscope photograph which shows the ultra-deep shape of a plating section of a pattern with a line /space ratio (L/S) of 20μm/20μm obtained in Example 5.

Figure 13 is a microscope photograph which shows the ultra-deep shape of a plating section of a pattern with a width of 100μm obtained in Example 5.

Figure 14 is a microscope photograph which shows the ultra-deep shape of a plating section of a pattern with a line/space ratio (L/S) of 20μm/20μm obtained in Example 6.

Figure 15 is a microscope photograph which shows the ultra-deep shape of a plating section of a pattern with a width of 100μm obtained in Example 6.

Figure 16 is a sectional view of a via to describe the via measurement.

## Detailed Description of the Invention

Throughout the specification, the term "plating solution" and the term "plating bath" are used interchangeably. The symbol °C means degree centigrade, g/L means gram per liter, ml/L means milliliter per liter, μm means micrometer, m/min means meter per minute, SPS means bis-(sodium sulfopropyl)-disulfide, and $A/dm^2$ and ASD mean ampere per square decimeter.

"Rectangularization" means making the section of the copper circuit pattern a "rectangular" shape with a flat or substantially flat top and sides perpendicular or substantially perpendicular to the bottom and top.

The present invention relates to an electrolytic copper plating solution which contains a non-ionic surfactant and an alkyl betaine surfactant, which is an alkyl imidazolium betaine surfactant.

This invention also relates to a method for electrolytic plating of a board by using the electrolytic copper plating solution.

Additionally, this invention relates to an electronic circuit which is manufactured by electrolytic plating of a board using the electrolytic copper plating solution.

Examples of non-ionic surfactant include but are not limited to polyethylene glycol (PEG); polyoxypropylene glycol; block copolymer or random copolymer of polyethylene glycol and polypropylene glycol; or polyethylene glycol or polypropylene added by alkyl ether. One, two or more types of non-ionic surfactants can be used. The content of the non-ionic surfactant is preferably 0.005 to 10 g/L, or more preferably 0.05 to 2 g/L. The molecular weight of the non-ionic surfactant (weight-average molecular weight) is preferably 500 to 12,000.

The plating solution of this invention also contains an alkyl betaine surfactant. The plating solution with superior effects of this invention can be obtained by the combined use of alkyl betaine surfactant and non-ionic surfactant. Here, the alkyl betaine surfactant is a compound that contains quaternary ammonium and carboxyl group in its molecule.

One, two or more kinds of alkyl betaine surfactants can be used. The content of the alkyl betaine surfactant is preferably 10-100 mg/L, and more preferably 10-80 mg/L.

The alkyl betaine surfactant is an alkyl imidazolium betaine surfactant. Alkyl imidazolium betaine surfactant can be alkyl imidazolium betaine compound. Imidazolium ring in alkyl imidazolium betaine can also be of ring-opening structure. Alkyl group of alkyl imidazolium betaine is the straight chain or branched alkyl group of, for example, carbon atoms numbering from 1-24, preferably 1-12.

Examples of alkyl imidazolium betaine are SOFTAZOLINE™ CH, SOFTAZOLINE™ CH-R, SOFTAZOLINE™ CL, SOFTAZOLINE™ CL-R, SOFTAZOLINE™ LHL, SOFTAZOLINE™ LHL-SF, SOFTAZOLINE™ NS, SOFTAZOLINE™ SF and SOFTAZOLINE™ SFD of Kawaken Fine Chemicals Co., Ltd., LEVON™ 105 and LEVON™ CIB of Sanyo Chemical Industries, Ltd. as well as NISSAN ANON™ GLM-R and NISSAN ANON™ GLM-R-LV of NOF Corporation.

The imidazolium betaine is a compound indicated by the following structural formula (4).

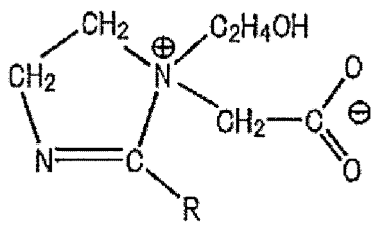

(4)

In Formula 4, R is the straight chain or branched alkyl group of carbon atoms numbering 1-24, preferably 1-12.

The electrolytic copper plating solution of this invention contains copper ion and acid and optionally contains halogen ion compounds other than the two kinds of surfactants stated above.

Copper ions can be added to the plating solution as a water-soluble copper salt and any compound that generates copper ions in water can also be used. Examples of copper ion sources include copper sulfate, copper chloride, copper acetate, methanesulfonic acid copper and cupric fluoroborate, among which, copper sulfate is especially preferred. The content of copper ions is 10-70 g/L, preferably 25-60 g/L.

Acid contained in the electrolytic copper plating solution of this invention can be inorganic acid or organic acid. These acids adjust the pH of the plating solution to acidity and serves as the conductive salt in the plating solution. Examples of acids include hydrochloric acid, sulfuric acid, nitric acid, methanesulfonic acid, fluoboric acid and phenolsulfonic acid, and most preferably sulfuric acid. The acid content is 10-180 g/L, preferably 30-150 g/L.

The electrolytic copper plating solution of this invention can contain halogen ions. Halogen ions serve as the gloss assistant jointly with surfactant in the plating solution. Chloride ions and bromine ions can be used as halogen ion. The content of halogen ion is 1-200 mg/L, preferably 25-75 mg/L.

The plating bath of this invention is an acid bath, because sediment of copper hydroxide or copper oxide will occur if the bath is neutral or alkali. The pH value of the plating bath is preferably below 4, and more preferably below 1.

The electrolytic plating solution of this invention can contain an additive which is usually used in an electrolytic copper plating solution such as leveler as necessary.

Solvent used in the electrolytic copper plating solution of this invention is water or water which contains alcohol like methanol or ethanol.

The electrolytic copper plating bath of this invention can be used to form copper plating deposits on a board. It is desirable to provide conductivity in advance where copper plating is deposited on the board. The electrolytic copper plating solution of this invention is specifically suitable for electrolytic copper plating of a fine pitch circuit. A fine pitch circuit is a circuit whose pattern has a width ranging from a few to dozens of micro-meters.

It is necessary to deposit copper plating without a void inside the resist pattern when forming a fine pitch circuit with electrolytic copper plating. If a void exists in the plating deposit inside the resist pattern, electric wiring there will be thinner, or, in an extreme case, the circuit will be cut off.

As stated above, because a copper circuit pattern is formed perpendicular to the board substrate, in the case that copper is deposited without a void inside the resist pattern, the deposited copper circuit pattern will have a section of a rectangular shape whose sides are at a right angle or substantially right angle to its bottom and top. On the other hand, in the case of insufficient plating deposit, the top will become low without plating deposited to the desirable height and the top of the copper circuit pattern will become dimpled sometimes without copper plating deposited at the corner part of the resist pattern bottom. This insufficient plating condition can be identified when observing shape of the section of the pattern after plating.

Although there is no restriction on the width and depth of the gap of the resist pattern used in the electrolytic copper plating of this invention, the width is below 200 micro-meters, preferably below 100 micro-meters, more preferably below 50 micro-meters or most preferably below 20 micro-meters, and the depth of the resist pattern ranges from 5 micro-meters and 30 micro-meters, preferably ranges from 7 micro-meters to 25 micro-meters. There are vias, for example, cylindrical holes with a diameter of 30-80 micrometers and a depth of 20-60 micrometers, in addition to fine wiring patterns depending on the boards and copper plating is performed at the same time for the vias and fine wiring pattern. However, because the gapes of fine wiring patterns and vias are greatly different in the opening diameter and depth, it is often found that copper deposit in some parts is insufficient even if copper deposit is superior in other parts. The electrolytic copper plating solution of this invention will deliver good copper deposits everywhere without voids.

When performing electrolytic copper plating on a board by using the electrolytic copper plating solution of this invention, any methods commonly used in electrolytic copper plating can be used. For example, cause a board which has received conductivity treatment to come in contact with the plating solution of this invention to allow the current to flow between electrodes and the plated board.

The temperature of the electrolytic copper plating solution is preferably 5-50 °C, and more preferably 20-28 °C. To perform plating, the current can be direct current or pulse current. Current density is preferably 0.5-4 $A/dm^2$, and more preferably 1-3 $A/dm^2$.

The following examples are included to further illustrate the present invention but are not intended to limit its scope.

Example 1

Prepare an electrolytic solution of the following composition.

Composition of the plating solution

| | | |
|---|---|---|
| Copper sulfate pentahydrate | : 200 g/L | (80 g/L of copper) |
| Sulfuric acid | : 100 g/L | |
| Chloride ion | : 50 g/L | |
| SPS | : 2 mg/L | |

Surfactant 1: non-ionic surfactant 1 (copolymer of polyethylene glycol and polypropylene glycol) (UCON (trademark) Lubricant 50 HB260) of 1g/L.

Surfactant 2: alkylamidopropyl betaine surfactant 1 (coconut oil fatty acid amidopropyl betaine: SOFTAZOLINE™ CPB-R produced by Kawaken Fine Chemical Co., Ltd., hereinafter referred to as "Amido type 1") 50 mg/L.

Residual: deionized water

Perform acid cleaning with ACID CLEANER™ 1022-B: 10% made by Rohm and Haas Electronic Materials, at 40 °C for 3 minutes on a panel board which has micro vias in a diameter of 65 μm and depth of 35 μm and a pattern board which has a resist pattern shape of 25 μm deep at a line/space ratio (L/S) of 20μm/20μm and a resist pattern shape which has a gap of 100 μm wide and 25 μm deep, wash with water at 30-40 °C for 1 minute and then wash with deionized water at room temperature for 1 minute. Next, perform acid cleaning with 10% sulfuric acid for 1 minute. Then,

use the plating solution stated above to conduct electrolytic copper plating at room temperature for 36 minutes at 1.5 ASD. The target copper plating thickness is 12 μm. Use phosphorus containing copper as electrodes. Then, wash with deionized water and observe the section shape of the circuits obtained under an ultra-depth shape measurement microscope VK-8510 (made by KEYENCE).

Example 2

Replace surfactant 1 with non-ionic surfactant 2 (copolymer of polyethylene glycol and polypropylene glycol) UCON™ Lubricant 50HB of 2,000 lg/L and replace surfactant 2 with alkylamidopropyl betaine surfactant 2 (AMOGEN™ CBH made by JEIL Industry, hereinafter referred to as "Amido type 2"), 50 mg/L. Other operations are the same as those in Example 1.

Example 3

Replace surfactant 2 with alkyl imidazolium betaine surfactant 1 (2-alkyl-N-carboxymethyl-N-hydroxyethyl imidazolium betaine: SOFTAZOLINE™ CL-R made by Kawaken Fine Chemical Co., Ltd., hereinafter referred to as "imidazolium type 1"), 50 mg/L. Other operations are the same as those in Example 1.

Example 4

Replace surfactant 2 with alkyl imidazolium betaine surfactant 2 (2-alkyl-N-carboxylmethyl-N-hydroxyethyl imidazolium betaine: SOFTAZOLINE™ CH-R made by Kawaken Fine Chemical Co., Ltd., hereinafter referred to as "imidazolium type 2") of 50mg/L. Other operations are the same as those in Example 1.

Example 5

Replace surfactant 2 with alkyl imidazolium betaine surfactant 3 (N-coconut oil fatty acid acyl-N'-carboxyethyl-N'-hydroxyethylethylene diamine sodium: SOFTAZOLINE™ SFD made by Kawaken Fine Chemical Co., Ltd., hereinafter referred to as "imidazolium type 3"), 50 mg/L. Other operations are the same as those in Example 1.

Example 6

Replace surfactant 2 with alkyl imidazolium betaine surfactant 4 (N-coconut oil fatty acid acyl-N'-carboxyethyl-N'-hydroxyethylethylene diamine sodium: SOFTAZOLINE™ NS made by Kawaken Fine Chemical Co., Ltd., hereinafter referred to as "imidazolium type 4"), 30 mg/L. Other operations are the same as those in Example 1.

Reference Example 1

Surfactant 2 is not added. Other operations are the same as those in Example 1.

Reference Example 2

Replace surfactant 2 with the compound expressed by the following structural formula (cation surfactant, JEFFAMINE™ T-403 Polyetheramine made by HUNTSMAN, hereinafter referred to as "cation system"), 10mg/L. Other operations are the same as those in Example 1.

Compound 5

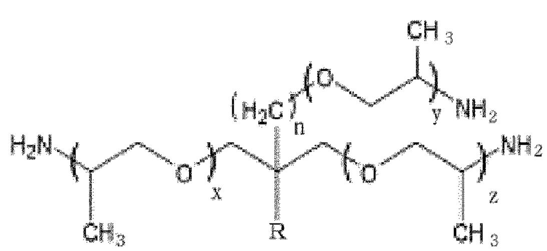

Reference Example 3

Replace surfactant 2 with cation polymer compound expressed by the following structural formula (ETHOMEEN™ C/25 cation polymer made by Lion Specialty Chemicals, hereinafter referred to as "cation polymer 1"), 10 mg/L. Other operations are the same as those in Example 1.

Compound 6

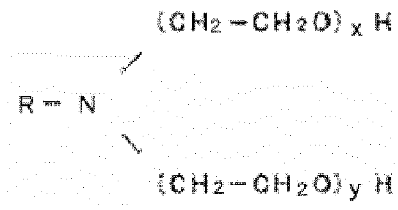

Reference Example 4

Replace surfactant 2 with cation polymer compound expressed by the following structural formula (Ethopropomeen C18-18 cation polymer made by Lion Specialty Chemicals, hereinafter referred to as "cation polymer 2") of 10mg/L. Other operations are the same as those in Example 1.

Compound 7

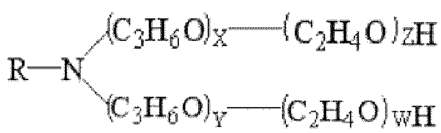

Reference Example 5

Replace surfactant 1 with anionic surfactant (Naphthalene-1,3,6-trisulfonic Acid Trisodium Salt Hydrate) and replace surfactant 2 with alkyl imidazolium betaine surfactant 5 (2-alkyl-N-carlboxymethyl-N-hedroxy ethyl imidazolium betaine: AMPHITOL™ 20Y-B made by Kao, hereinafter referred to as "imidazolium type 4"), 100 mg/L. Other operations are the same as those in Example 1.

Reference Example 6

Replace surfactant 1 with (copolymer of polyethylene glycol and polypropylene glycol) UCON™ Lubricant 75H-90000 and replace surfactant 2 with amphoteric surfactant of the following structure (laurylaminopropyl hedroxysultaine): SOTAZOLINE™ LSB-R made by Kawaken Fine Chemical Co., Ltd., hereinafter referred to as "amphoteric surfactant"), 10 mg/L. Other operations are the same as those in Example 1.

The results are shown in Table 1 and Table 2 below.

Table 1

| Example | 1 | 2 | 3 | 4 | 5 | 6 |
|---|---|---|---|---|---|---|
| Surfactant 1 | Non-ionic surfactant 1 | Non-ionic surfactant 2 | Non-ionic surfactant 1 | Non-ionic surfactant | Non-ionic surfactant 1 | Non-ionic surfactant |
| Surfactant 2 | Amide type 1 | Amide type 2 | Imidazolium type 1 | Imidazolium type 2 | Imidazolium type 3 | Imidazolium type 4 |
| Pattern shape (L/S ratio of 20 μm/20 μm | Rectangular (Figure 1) | Rectangular (Figure 3) | Rectangular (Figure 5) | Rectangular (Figure 10) | Rectangular (Figure 12) | Rectangular (Figure 14) |

(continued)

| Example | 1 | 2 | 3 | 4 | 5 | 6 |
|---|---|---|---|---|---|---|
| Pattern shape (diameter = 100μm) | Rectangular (Figure 2) | Rectangular (Figure 4) | Rectangular | Rectangular (Figure 11) | Rectangular (Figure 13) | Rectangular (Figure 15) |
| Via filling | -5.7 | 10.9 | 0.5 | 5.8 | 4.9 | 1.3 |
| Appearance | Gloss | Gloss | Nodule | Nodule | Nodule | Nodule |

Via filling is calculated in accordance with elevation difference between surface A and the lowest sunken part in the center of via hole or embossment part B. In case of sinking, it will be a plus value. In case of swelling and being filled, it will be represented by a minus value.

$$\text{Via filling} = \text{A-B}\ (\mu\text{m})$$

Table 2

| Reference example | 1 | 2 | 3 | 4 | 5 | 6 |
|---|---|---|---|---|---|---|
| Surfactant 1 | Non-ionic surfactant 1 | Non-ionic surfactant 1 | Non-ionic surfactant 1 | Non-ionic surfactant 1 | Anionic 1 | Surfactant 1 |
| Surfactant 2 | - | Cation system | Cation polymer 1 | Cation polymer 2 | Imidazolium type 4 | Amphoteric surfactant |
| Pattern shape (L/S ratio of 20/20) | The corners are of a round bulging shape | The corners are of a round bulging shape (Figure 6) | The corners are of a round bulging shape (Figure 8) | The corners are of a round bulging shape (Figure 9) | | |
| Pattern shape (L=100) | The corners are of a round bulging shape | The corners are of a round bulging shape (Figure 7) | | | | |
| Via filling | | 6.2 | 14.9 | 8.7 | 40.5 | 21.2 |
| Appearance | | Gloss | Gloss | Gloss | Nodule | Gloss |

## Claims

1. An electrolytic copper plating solution, **characterized in that** it comprises of water or a mixture of water and alcohol, copper ions, an acid, a non-ionic surfactant and an alkyl imidazolium betaine surfactant having the formula:

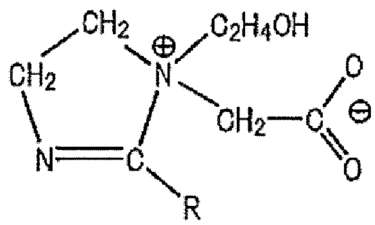

(4)

wherein R is a straight chain or branched alkyl group of carbon atoms numbering 1-24.

2. The electrolytic copper plating solution as stated in claim 1, wherein the content of the alkyl imidazolium betaine surfactant is 0.01-100 mg/L.

3. A method for providing electrolytic plating on an electronic circuit comprising a resist pattern and vias with the electrolytic copper plating solution as stated in claim 1 or claim 2 to deposit copper on the electronic circuit to fill the vias.

4. The electrolytic copper plating solution of claim 1, wherein the alkyl imidazolium betaine surfactant is included in the electrolytic copper plating solution in amounts of 10-100 mg/L.

5. The electrolytic copper plating solution of claim 1, wherein the non-ionic surfactant is selected from the group consisting of polyethylene glycol (PEG); polyoxypropylene glycol; block copolymer or random copolymer of polyethylene glycol and polypropylene glycol; or polyethylene glycol or polypropylene added by alkyl ether.

6. The electrolytic copper plating solution of claim 5, wherein the non-ionic surfactant is included in the electrolytic copper plating solution in amounts of 0.005 to 10 g/L.

## Patentansprüche

1. Eine Lösung zum elektrolytischen Kupferplattieren, **dadurch gekennzeichnet, dass** sie aus Wasser oder einer Mischung von Wasser und Alkohol, Kupferionen, einer Säure, einem nichtionischen Tensid und einem Alkylimidazoliumbetaintensid mit der folgenden Formel besteht:

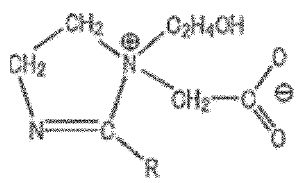

(4)

wobei R eine geradkettige oder verzweigte Alkylgruppe von Kohlenstoffatomen der Anzahl 1-24 ist.

2. Lösung zum elektrolytischen Kupferplattieren gemäß Anspruch 1, wobei der Gehalt an Alkylimidazoliumbetaintensid 0,01-100 mg/l beträgt.

3. Ein Verfahren zum Bereitstellen von elektrolytischer Plattierung auf einer elektronischen Schaltung, die ein Resistmuster und Durchkontaktierungen beinhaltet, mit der Lösung zum elektrolytischen Kupferplattieren gemäß Anspruch 1 oder Anspruch 2, um Kupfer auf der elektronischen Schaltung abzuscheiden, um die Durchkontaktierungen zu füllen.

4. Lösung zum elektrolytischen Kupferplattieren gemäß Anspruch 1, wobei das Alkylimidazoliumbetaintensid in der Lösung zum elektrolytischen Kupferplattieren in Mengen von 10-100 mg/l umfasst ist.

5. Lösung zum elektrolytischen Kupferplattieren gemäß Anspruch 1, wobei das nichtionische Tensid aus der Gruppe ausgewählt ist, die aus Folgendem besteht: Polyethylenglykol (PEG); Polyoxypropylenglykol; Blockcopolymer oder

statistischem Copolymer von Polyethylenglykol und Polypropylenglykol; oder Polyethylenglykol oder Polypropylen, ergänzt durch Alkylether.

6. Lösung zum elektrolytischen Kupferplattieren gemäß Anspruch 5, wobei das nichtionische Tensid in der Lösung zum elektrolytischen Kupferplattieren in Mengen von 0,005 bis 10 g/l umfasst ist.

## Revendications

1. Une solution de placage de cuivre électrolytique, **caractérisée en ce qu'**elle comprend de l'eau ou un mélange d'eau et d'alcool, des ions cuivre, un acide, un tensioactif non ionique et un tensioactif alkyl imidazolium bétaïne ayant la formule :

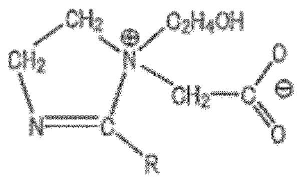
(4)

dans laquelle R est un groupe alkyle ramifié ou à chaîne linéaire d'atomes de carbone au nombre de 1 à 24.

2. La solution de placage de cuivre électrolytique telle qu'indiquée dans la revendication 1, dans laquelle la teneur en tensioactif alkyl imidazolium bétaïne va de 0,01 à 100 mg/L.

3. Un procédé pour fournir un placage électrolytique sur un circuit électronique comprenant un motif de matière de protection et des trous de liaison avec la solution de placage de cuivre électrolytique telle qu'indiquée dans la revendication 1 ou la revendication 2 afin de déposer du cuivre sur le circuit électronique pour remplir les trous de liaison.

4. La solution de placage de cuivre électrolytique de la revendication 1, dans laquelle le tensioactif alkyl imidazolium bétaïne est inclus dans la solution de placage de cuivre électrolytique dans des quantités de 10 à 100 mg/L.

5. La solution de placage de cuivre électrolytique de la revendication 1, dans laquelle le tensioactif non ionique est sélectionné dans le groupe constitué du polyéthylène glycol (PEG) ; du polyoxypropylène glycol ; d'un copolymère séquencé ou copolymère statistique de polyéthylène glycol et de polypropylène glycol ; ou du polyéthylène glycol ou du polypropylène additionné d'éther d'alkyle.

6. La solution de placage de cuivre électrolytique de la revendication 5, dans laquelle le tensioactif non ionique est inclus dans la solution de placage de cuivre électrolytique dans des quantités de 0,005 à 10 g/L.

FIG. 1

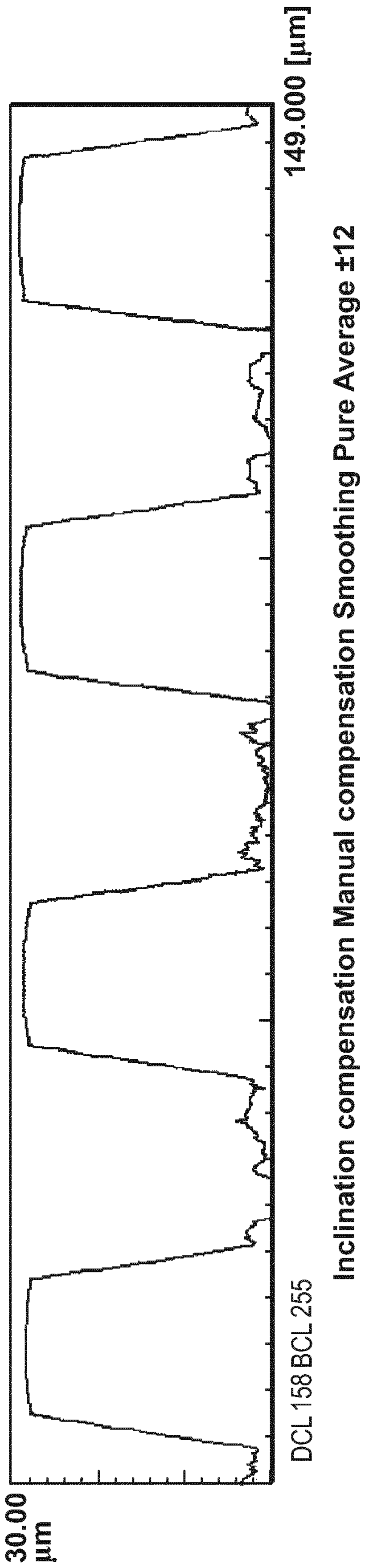
30.00
µm
149.000 [µm]
DCL 158 BCL 255
Inclination compensation Manual compensation Smoothing Pure Average ±12

FIG. 2

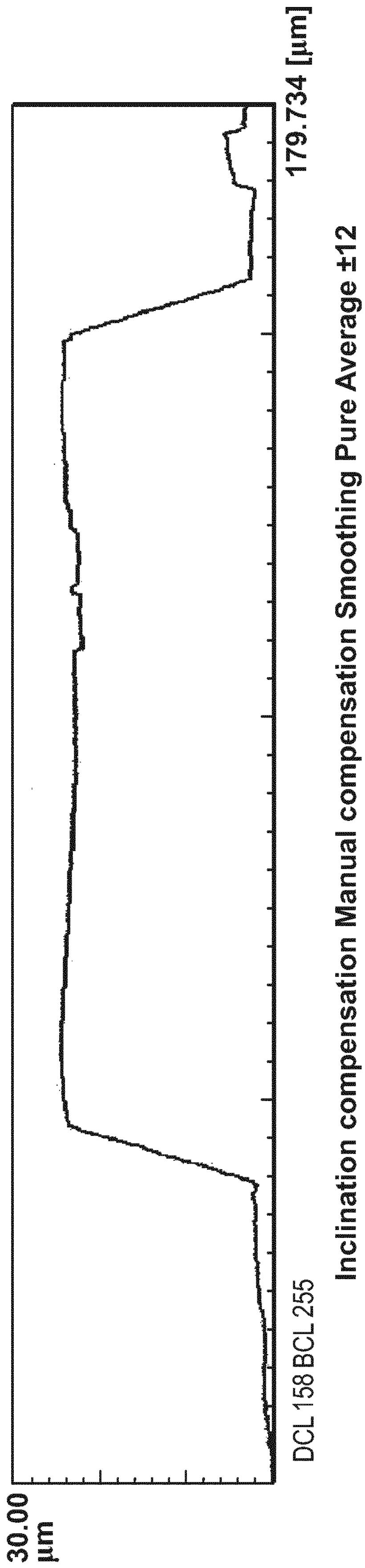
30.00
µm
179.734 [µm]
DCL 158 BCL 255
Inclination compensation Manual compensation Smoothing Pure Average ±12

FIG. 3

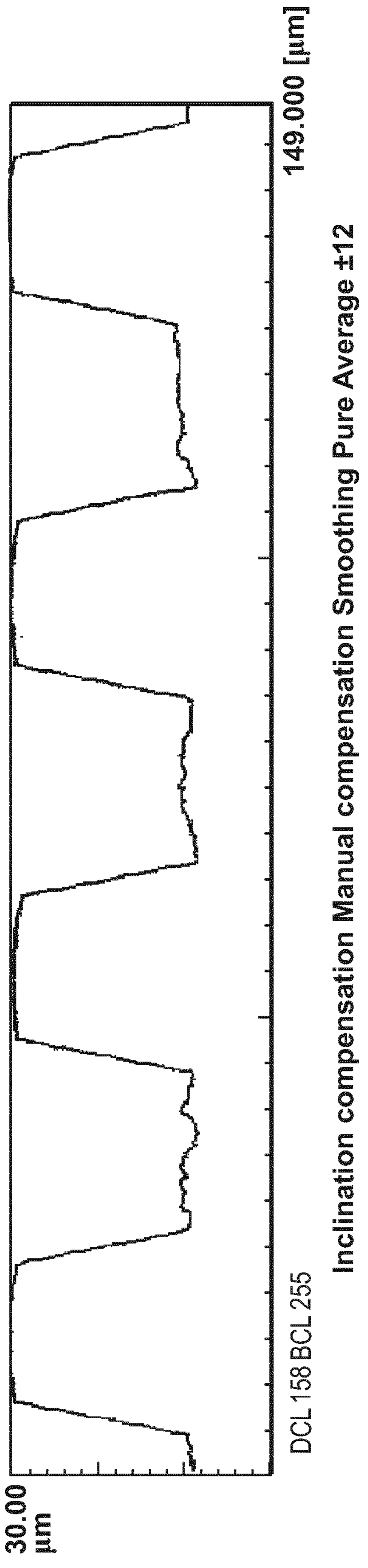
30.00
µm
149.000 [µm]
DCL 158 BCL 255
Inclination compensation Manual compensation Smoothing Pure Average ±12

FIG. 4

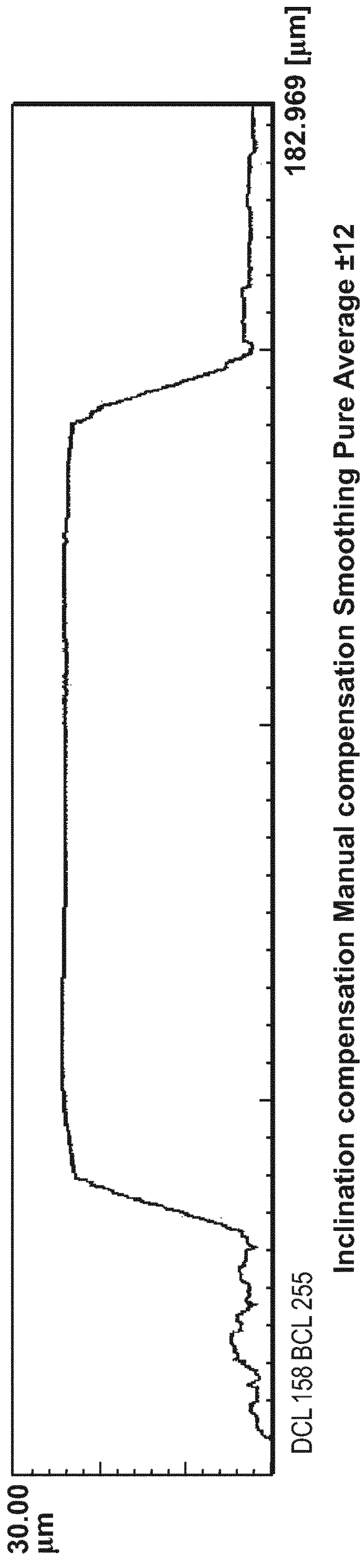
30.00
µm
182.969 [µm]
DCL 158 BCL 255
Inclination compensation Manual compensation Smoothing Pure Average ±12

FIG. 5

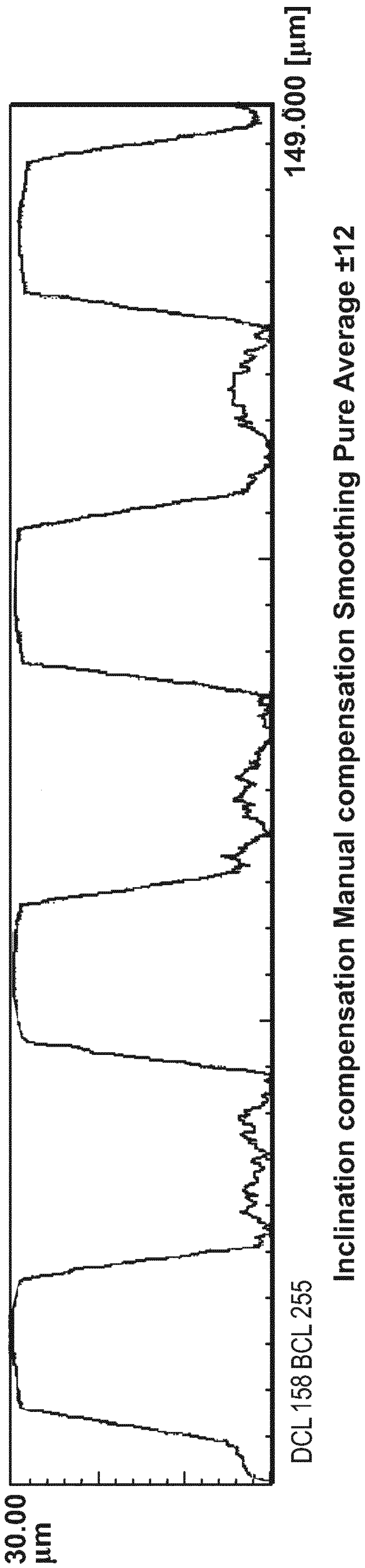
30.00
µm
149.000 [µm]
DCL 158 BCL 255
Inclination compensation Manual compensation Smoothing Pure Average ±12

FIG. 6

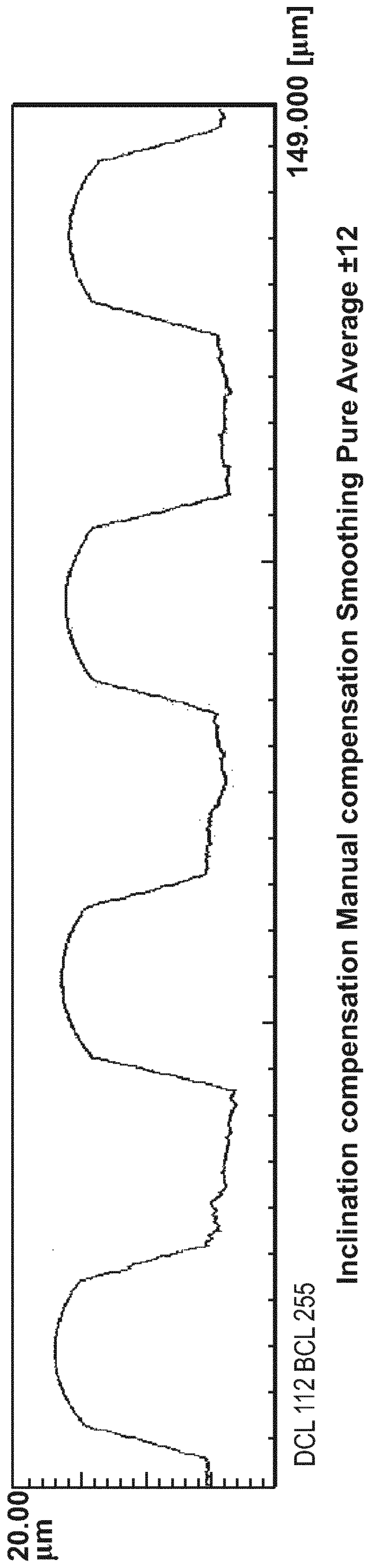
20.00
µm
149.000 [µm]
DCL 112 BCL 255
Inclination compensation Manual compensation Smoothing Pure Average ±12

FIG. 7

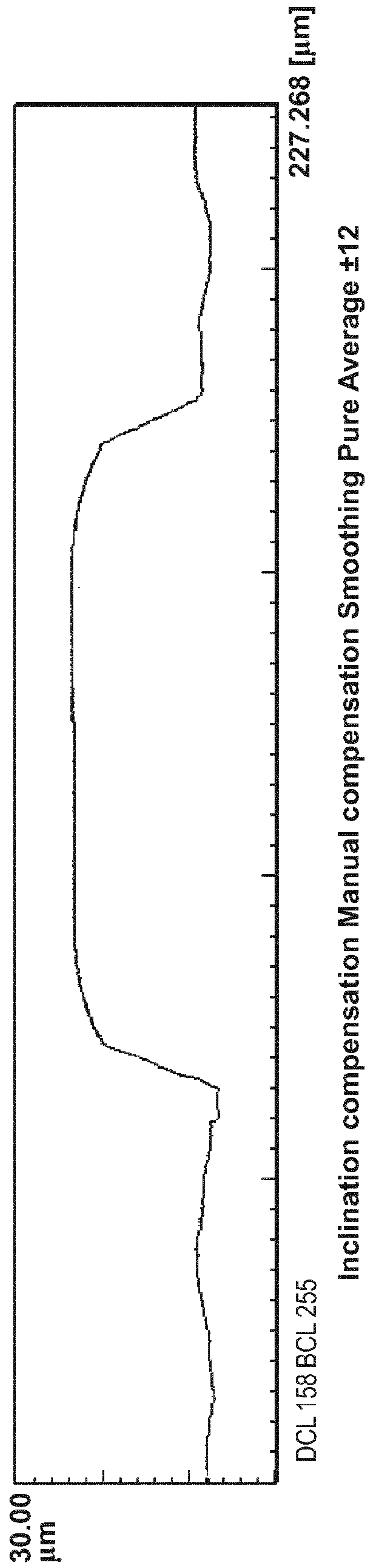
30.00
µm
227.268 [µm]
DCL 158 BCL 255
Inclination compensation Manual compensation Smoothing Pure Average ±12

FIG. 8

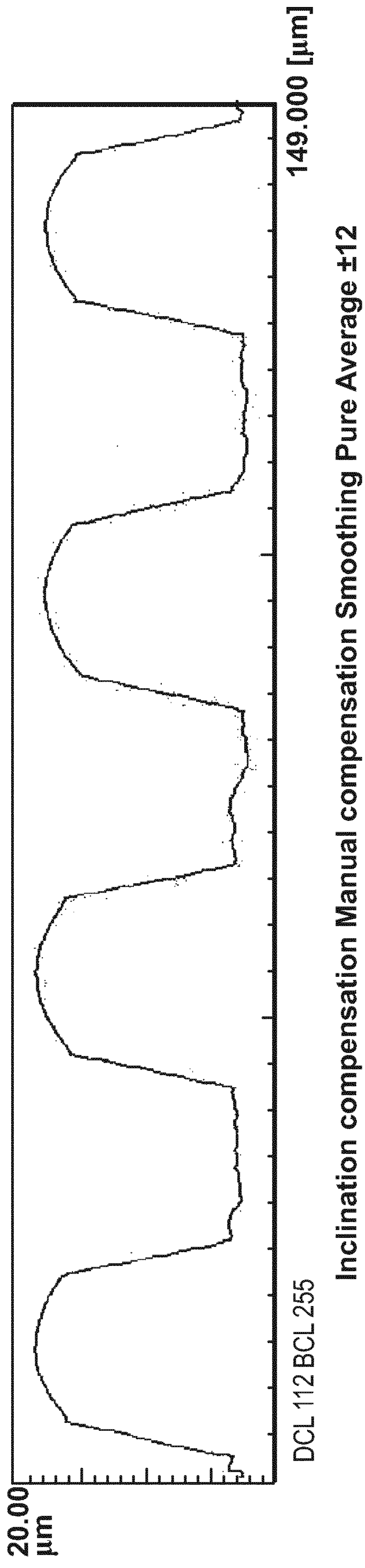
20.00
µm
149.000 [µm]
DCL 112 BCL 255
Inclination compensation Manual compensation Smoothing Pure Average ±12

FIG. 9

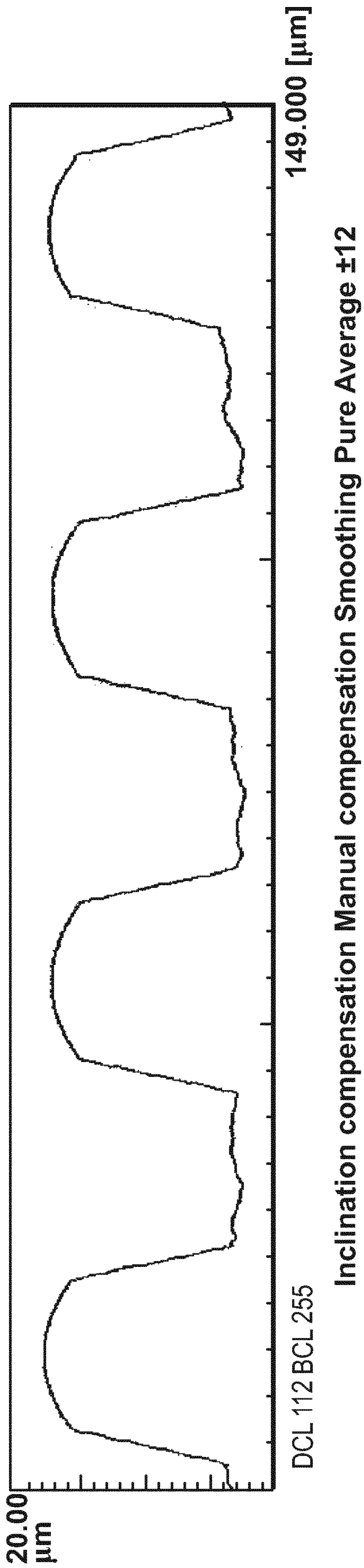
20.00
µm
149.000 [µm]
DCL 112 BCL 255
Inclination compensation Manual compensation Smoothing Pure Average ±12

FIG. 10

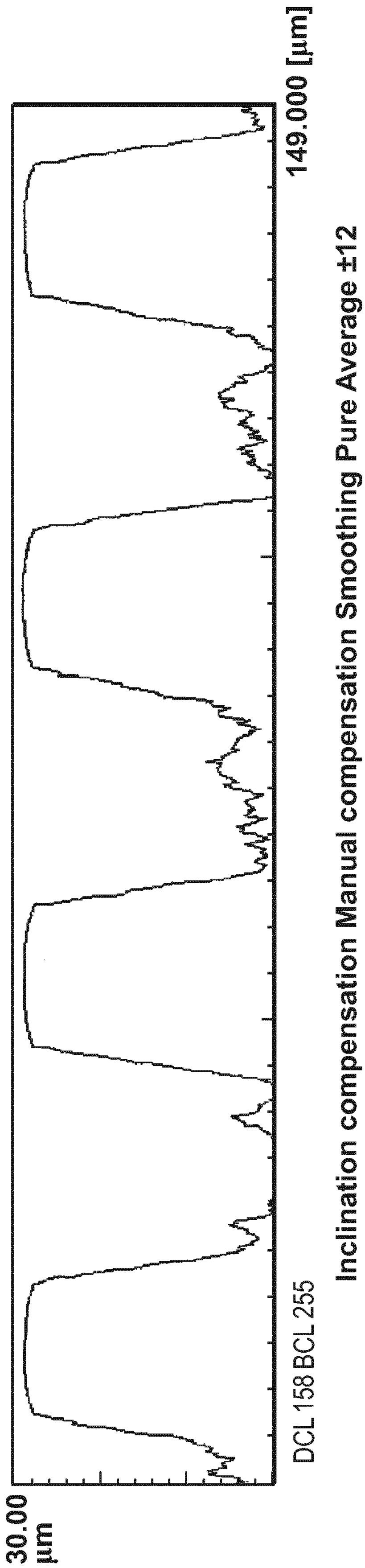
30.00
µm
149.000 [µm]
DCL 158 BCL 255
Inclination compensation Manual compensation Smoothing Pure Average ±12

FIG. 11

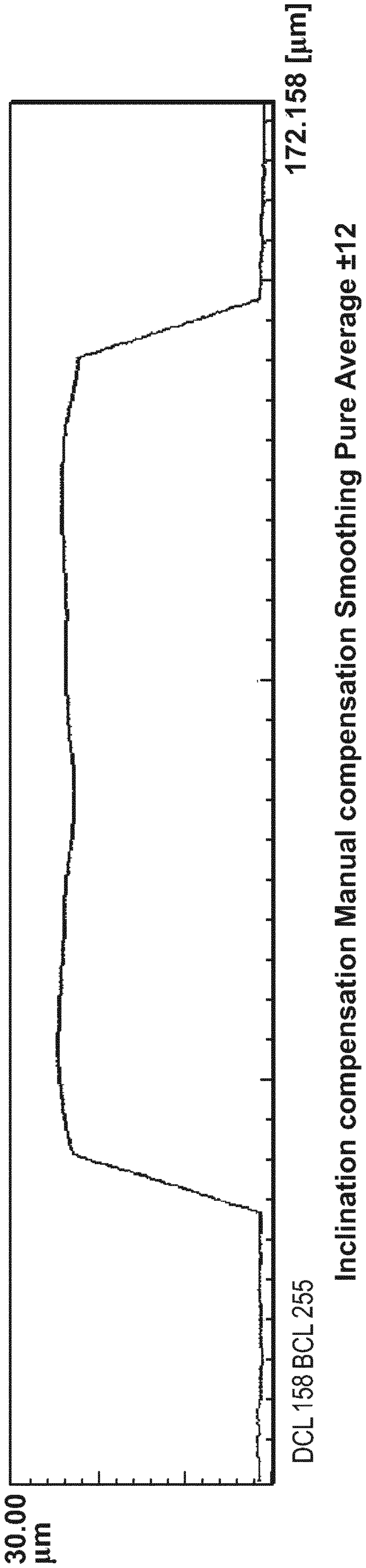
30.00
µm
172.158 [µm]
DCL 158 BCL 255
Inclination compensation Manual compensation Smoothing Pure Average ±12

FIG. 12

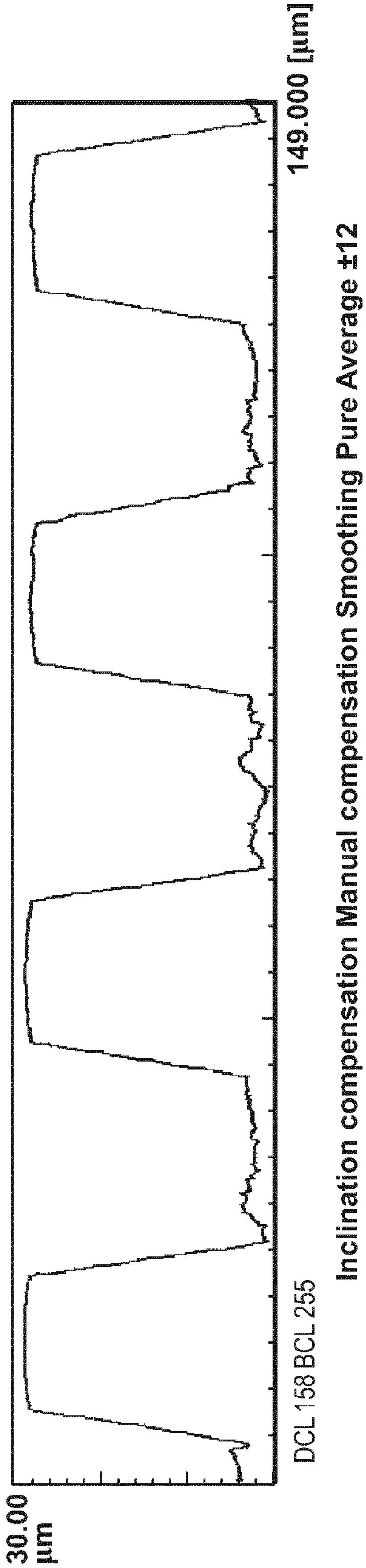
30.00
µm
149.000 [µm]
DCL 158 BCL 255
Inclination compensation Manual compensation Smoothing Pure Average ±12

FIG. 13

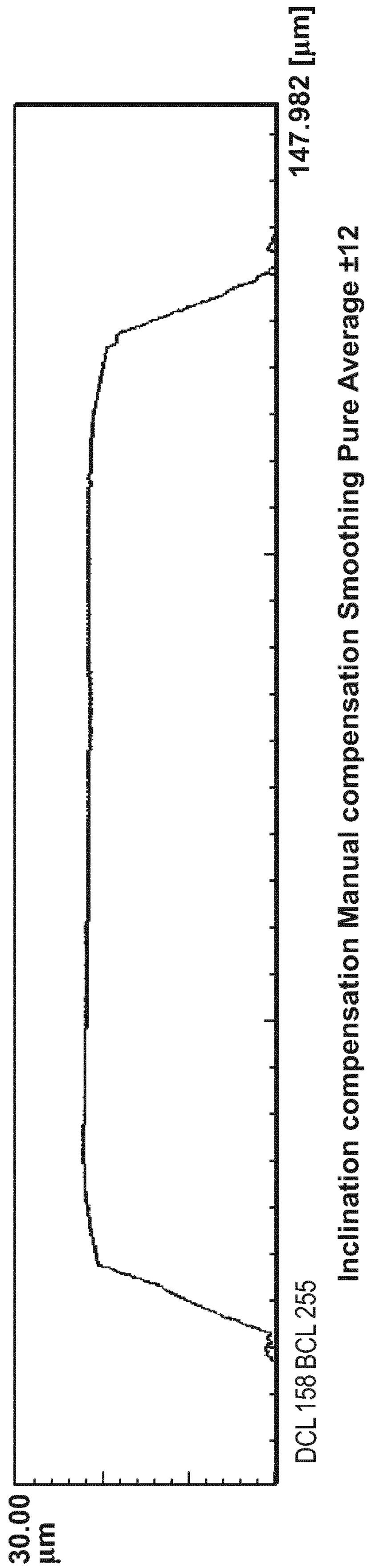
30.00
µm
147.982 [µm]
DCL 158 BCL 255
Inclination compensation Manual compensation Smoothing Pure Average ±12

FIG. 14

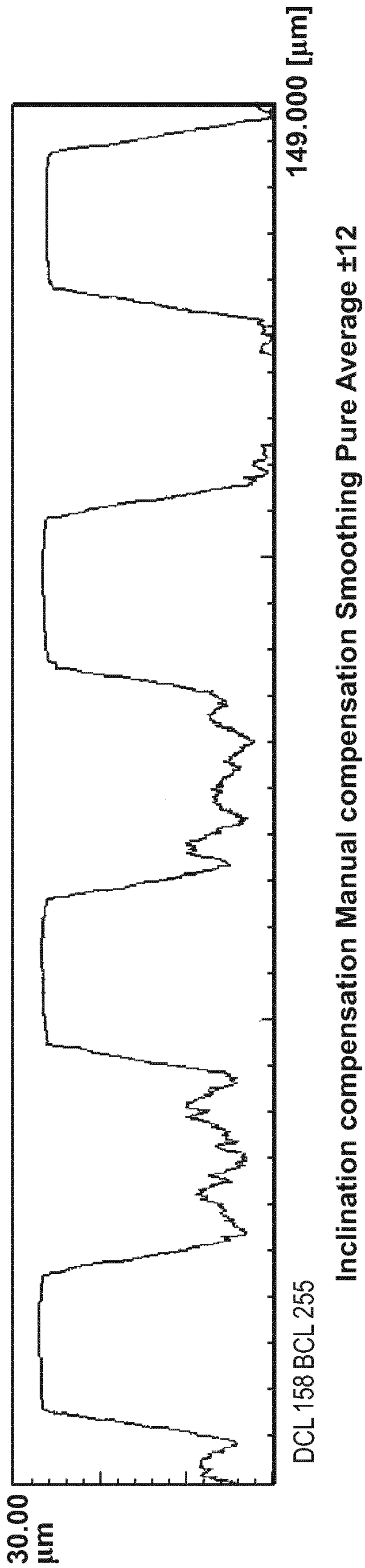
30.00
µm
149.000 [µm]
DCL 158 BCL 255
Inclination compensation Manual compensation Smoothing Pure Average ±12

FIG. 15

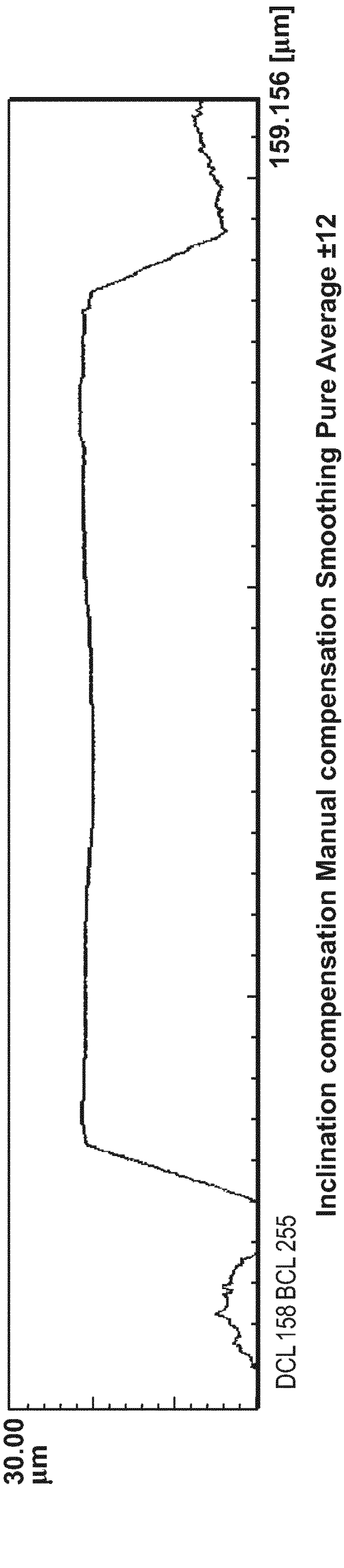
30.00
µm
159.156 [µm]
DCL 158 BCL 255
Inclination compensation Manual compensation Smoothing Pure Average ±12

FIG. 16

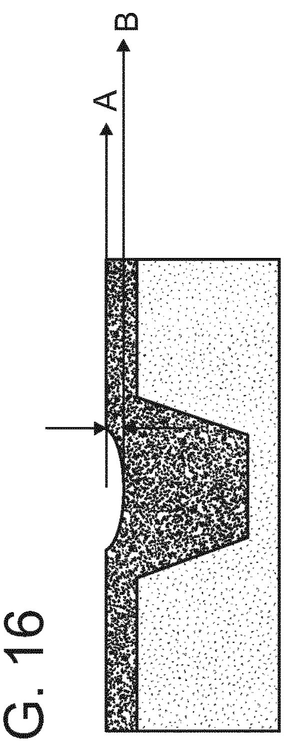
A
B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2005126740 A
- JP 2004307898 A
- US 2010084277 A
- US 2005072683 A


### Non-patent literature cited in the description


- **ATSUKI NOGAMI et al.** Fine-pitch and High-density Printed Circuit Board. *Fujikura Technical Review,* 01 January 2010